**Europäisches Patentamt**

**European Patent Office**

**Office européen des brevets**

(19)

(11) Veröffentlichungsnummer: **0 050 744
B1**

(12)

# EUROPÄISCHE PATENTSCHRIFT

(45) Veröffentlichungstag der Patentschrift:
02.05.85

(51) Int. Cl.⁴: **H 03 K 5/26, G 01 R 23/15**

(21) Anmeldenummer: **81107701.5**

(22) Anmeldetag: **28.09.81**

(54) Einrichtung zum Erkennen der Frequenzdrift einer Schwingschaltung.

(30) Priorität: **24.10.80 DE 3040198**

(43) Veröffentlichungstag der Anmeldung:
**05.05.82 Patentblatt 82/18**

(45) Bekanntmachung des Hinweises auf die Patenterteilung:
**02.05.85 Patentblatt 85/18**

(84) Benannte Vertragsstaaten:
**AT BE CH DE FR LI NL SE**

(56) Entgegenhaltungen:
**DE - A - 2 733 890
DE - B - 1 950 684**

**SIEMENS ZEITSCHRIFT, Band 48, Nr. 7, 1974, Berlin und München, G. KOPPERSCHMIDT "Taktversorgung und Überwachung im URTL-Schaltkreissystem U1", Seiten 503 bis 506**

(73) Patentinhaber: **Siemens Aktiengesellschaft, Berlin und München Wittelsbacherplatz 2, D-8000 München 2 (DE)**

(72) Erfinder: **Sporleder, Heinrich, Dipl.-Ing., Elmhöhe 2, D-3300 Braunschweig (DE)**

EP 0 050 744 B1

## Beschreibung

In Datenverarbeitungsanlagen mit synchroner Arbeitsweise wird der zeitliche Ablauf der einzelnen Operationen durch Taktgeber gesteuert. Als Taktgeber finden häufig quarzstabilisierte Oszillatoren oder Multivibratoren Anwendung; an ihren Ausgängen ist der Takt meist in Impulsen mit konstanter Impulsfolgefrequenz abgreifbar.

Häufig werden für den Betrieb einer Anlage mehrere Taktsignale benötigt, die gegeneinander phasenverschoben sind. Ein derartiger Taktgeber ist beispielsweise beschrieben in einem Aufsatz mit dem Titel «Taktstromversorgung und Überwachung im URTL-Schaltkreissystem U1» (Siemens Zeitschrift 48 (1974) Heft 7, Seiten 503 bis 506). Bei diesem bekannten Taktgeber gibt ein quarzstabilisierter Generator Impulse ab, die über eine signaltechnisch sichere Torschaltung eine monostabile Kippstufe triggern. Diese Kippstufe ist das erste Glied einer Kaskadenschaltung aus mehreren monostabilen Kippstufen, von denen jede beim Zurückfallen in den stabilen Zustand die folgende Kippstufe ansteuert. Die von den einzelnen monostabilen Kippstufen vorgegebenen Zeiten entsprechen dabei den einzelnen Impulsabständen der für die Steuerung benötigten phasenverschobenen Taktsignale. Die in der Kaskadenschaltung an letzter Stelle vorgesehene monostabile Kippstufe erzeugt einen sehr schmalen Fensterimpuls, in den zeitlich der nächste vom quarzstabilisierten Generator abgegebene Impuls fallen muss, damit die in der Reihenschaltung an erster Stelle vorgesehene monostabile Kippstufe der Kaskadenschaltung wieder betätigt werden und der vorerwähnte Vorgang erneut ablaufen kann. Ändert sich z.B. infolge eines Driftvorganges die Periodendauer des quarzstabilisierten Generators, so beträgt diese nicht mehr ein ganzzahliges Vielfaches der Gesamtlaufzeit der in Reihe geschalteten monostabilen Kippstufen. Die Fensterimpulse und die vom Generator abgegebenen Impulse laufen dann auseinander, bis einer der Taktimpulse zeitlich gesehen neben einem Fensterimpuls liegt. Bei dieser Konstellation sperrt die signaltechnisch sichere Torschaltung die weitere Triggerung der Kippstufen. Die Kippstufen geben daraufhin an ihren Ausgängen an Stelle von antivalenten nur noch statische Signale ab; dies wirkt sich in den angeschlossenen Schaltwerken so aus, dass dort keine weitere Verarbeitung mehr stattfinden kann. Damit kann das durch den Taktgeber geleitete Schaltwerk im Störungsfall auch keine für den Betrieb gefährlichen Informationen ausgeben.

Während ein echter Defekt im Taktgeber oder an einer der monostabilen Kippstufen zur sofortigen Unterbrechung der weiteren Datenverarbeitung führt, macht sich das allmähliche Driften der Quarzfrequenz des Taktgebers erst bemerkbar, wenn die Abweichung gegenüber dem Frequenznormal einen bestimmten Wert übersteigt; dieser Wert kann systembedingt in der Grössenordnung von ±10% der Normalfrequenz liegen.

Es gibt auch andere Möglichkeiten, die Frequenzdrift einer Schwingschaltung zu erkennen. So beschreibt z.B. die DE-A1 2 733 890 ein Verfahren zum hochgenauen Messen von Phasen- und Frequenzdifferenzen bei Schwingschaltungen, denen gesonderte Schwingschaltungen zur Vorgabe von Bezugsschwingungen beigeordnet sind. Nach diesem bekannten Verfahren werden die Mess- und die Bezugsschwingung über nachgeschaltete Frequenzteiler einem Phasendetektor zugeführt. Dieser Phasendetektor besteht im wesentlichen aus einem Flipflop, dessen Setzeingang die Bezugs- und dessen Rücksetzeingang die Messsignale zugeführt werden. An seinem Ausgang gibt der Phasendetektor Phasensignale ab, deren Impulsdauern proportional sind der augenblicklichen Phasendifferenz zwischen den Bezugssignalen und den Messsignalen. Die Auswertung der Phasensignale erfolgt digital durch eine Zeitmessung mit nachfolgender Bewertung der Zeitmessergebnisse. Die Qualität des Messergebnisses ist abhängig von der zeitlichen Auflösung der Phasensignale und der Genauigkeit der Auflösung. Die Auflösung muss – um schon relativ geringe Driftvorgänge erkennen zu können – ausserordentlich hoch sein und stellt daher erhebliche Anforderungen an die Auswertung, insbesondere bei der Bewertung hochfrequenter Schwingungen.

Aufgabe der vorliegenden Erfindung ist es, eine Einrichtung nach dem Oberbegriff des Patentanspruches 1 anzugeben, die schon auf geringe Abweichungen vom Frequenznormal reagiert, dabei aber ohne aufwendige Auswertung auskommt und das Bewertungsergebnis in Form einer einfachen Ja-/Nein-Entscheidung zur Verfügung stellt. Die Ansprechschwelle für die Einrichtung soll dabei bedarfsweise einstellbar sein.

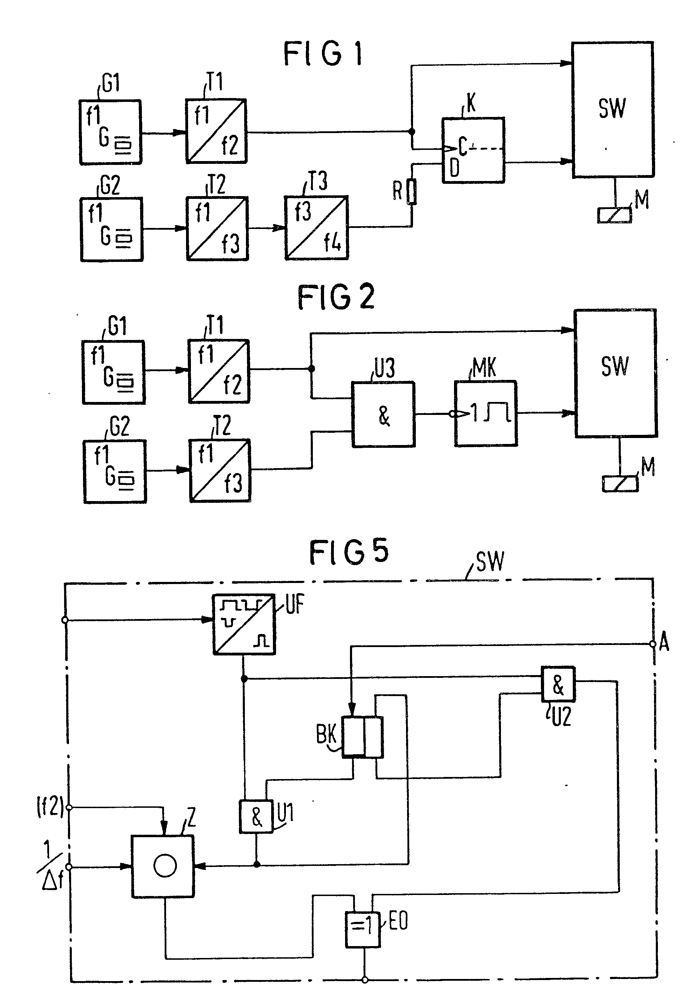

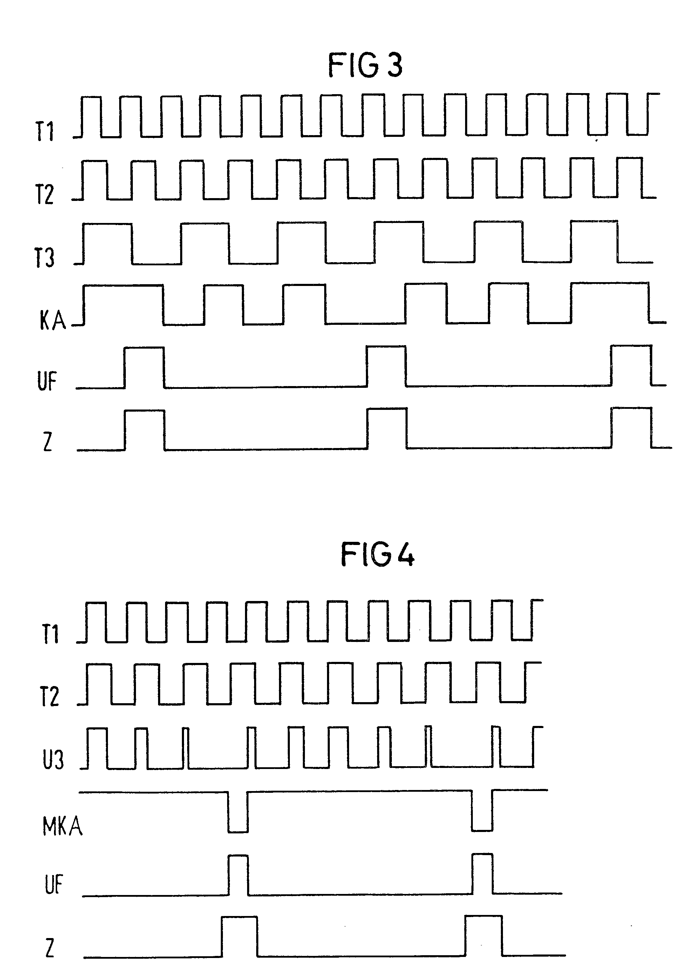

Die Erfindung löst diese Aufgabe durch die im Kennzeichen des Patentanspruches 1 angegebenen Merkmale. Besonders vorteilhafte Ausgestaltungen der erfindungsgemässen Einrichtung sind in den Unteransprüchen angegeben. Die Erfindung ist nachstehend anhand der Zeichnung näher erläutert. Die Figuren 1 und 2 zeigen zwei Ausführungsbeispiele der erfindungsgemässen Einrichtung, die Figuren 3 und 4 zugehörige Impulsdiagramme und die Figur 5 den Aufbau eines Schaltwerkes zur Ausgabe einer eine unzulässige Frequenzdrift kennzeichnenden Meldung, wie es in den Ausführungsbeispielen der Figuren 1 und 2 schematisch angedeutet ist.

In Figur 1 besteht die zu überwachende Schwingschaltung aus einem quarzstabilisierten Generator G1 mit der Frequenz f1 und einem nachgeschalteten Frequenteiler T1 für die Frequenzen f1 und f2. Zum Feststellen einer möglichen Frequenzdrift ist dem Generator G1 ein weiterer Generator G2 zur Vorgabe einer gleichfrequenten Bezugsschwingung beigeordnet. Diesem Generator nachgeschaltet ist ein Frequenzteiler T2 für die Frequenzen f1 und f3. Die Frequenz f3 unterscheidet sich von der Frequenz f2 durch einen Faktor $\Delta f2 = \frac{f2-f3}{f2}$ der zu überwachenden Schwingung. Dieser Faktor (im Beispiel = ⅙) bestimmt – wie noch zu erläutern ist – die Zeitspanne, in der eine mögliche Frequenzdrift der zu überwachenden Schwingschaltung sich für den Überwachungsvorgang auswirken kann. Je kleiner dieser Faktor ist, um so grösser ist die Messzeit und um so kleiner ist die von der Einrichtung erkennbare Frequenzdrift. Eine nachgeschaltete Phasenvergleichsschaltung zur Bewertung der Mess- und der Bezugsschwingung besteht aus einem weiteren Frequenzteiler T3, einem D-Kippglied K und einem Schaltwerk SW. Der weitere Frequenzteiler T3 ist dabei dem Frequenzteiler T2 für die Frequenzen f3 und f4 nachgeschaltet. Er teilt die Frequenz der ihm zugeführten Signale im Verhältnis 2:1; gleichzeitig sorgt er für ein symmetrisches Tastverhältnis der an seinem Ausgang abgreifbaren Signale. Der Ausgang des Frequenzteilers T3 ist über einen Entkopplungswiderstand R zum Entkoppeln von G1/T1 gegen G2/T2/T3 an den D-Eingang des nachgeschalteten D-Kippgliedes K geführt, das durch die auf seinen C-Eingang geführten Ausgangssignale des Frequenzteilers T1 getriggert ist. Der Ausgang des Kippgliedes K ist auf ein Schaltwerk SW geführt, dessen Aufbau in Figur 5 angegeben ist. Zur Verdeutlichung der Vorgänge, die erfindungsgemäss zum Erkennen einer vorgegebenen Frequenzdrift in der Phasenvergleichsschaltung führen, ist nachstehend Bezug genommen auf das Schaubild der Figur 3. Die obere Zeile der Figur 3 zeigt die am Ausgang des Frequenzteilers T1 abgreifbaren Signale, deren mögliche Frequenzdrift erkannt werden soll. In der darunterliegenden zweiten Zeile der Figur 3 sind die am Ausgang des Frequenzteilers T2 und in der dritten Zeile die am Ausgang des Frequenzteilers T3 abgreifbaren Signale dargestellt. Der Beginn des dargestellten Beobachtungszeitraumes ist dabei so gewählt, dass die Ausgänge beider Frequenzteiler gleichzeitig H-Potential führen. Zum Verdeutlichen der der Erfindung zugrundeliegenden Überlegungen und Erkenntnisse ist ferner angenommen, dass die Periodendauer der vom Frequenzteiler T2 abgegebenen Signale die Periodendauer der vom Frequenzteiler T1 abgegebenen Signale um 20% übersteigt, d.h. $f3/f2 = \frac{1}{1,2}$ .

In der vierten Zeile der Figur 3 sind die Ausgangssignale des Kippgliedes K aufgetragen. In den Zeitpunkten, in denen das Triggersignal am D-Eingang des Kippgliedes H-Potential antrifft, steuert es das Kippglied in den Schaltzustand, in dem dieses an seinem Ausgang H-Potential führt; liegt der D-Eingang des Kippgliedes zum Triggerzeitpunkt auf L-Potential, wechselt das Ausgangspotential des Kippgliedes K von H- auf L-Potential.

Das von den Ausgangssignalen des Kippgliedes K gesteuerte Schaltwerk SW dient dazu, die über jeweils zwei Perioden der zu überwachenden Schwingung anstehenden gleichförmigen Signale zu erkennen und zu prüfen, ob diese Signale in einen dem Schaltwerk fest eingeprägten zeitlichen Rahmen fallen oder nicht. Treten diese Signale zur Unzeit auf, so löst das Schaltwerk SW über einen nachgeschalteten Melder M eine Meldung aus, die beispielsweise zum Abschalten der Schwingschaltung oder der von ihr gesteuerten Schaltmittel führen kann.

Eine Möglichkeit zur technischen Realisierung des Schaltwerkes SW ist in Figur 5 dargestellt. Das Schaltwerk enthält einen Umformer UF, der von den Ausgangssignalen KA des D-Kippgliedes K gespeist ist. Der Umformer UF ist so ausgebildet, dass er an seinem Ausgang so lange L-Potential führt als ihm auf seinem Eingang zyklisch alternierende Signale zugeführt werden, deren Folgefrequenz halb so gross ist wie die Frequenz der zu überwachenden Schwingschaltung. Registriert der Umformer UF ein über mehr als eine Periode der zu überwachenden Schwingung anstehendes gleichförmiges Eingangssignal, so wechselt sein Ausgangssignal bis zum Empfang des nächsten Umsteuersignals von L- auf H-Pegel. Das Ausgangssignal des Umformers UF ist in der fünften Zeile der Figur 3 graphisch dargestellt.

Das erste vom Umformer UF geschaltete H-Potential dient im Schaltwerk dazu, das Schaltwerk mit den vom Umformer UF gelieferten H-Signalen zu synchronisieren und damit nachgeordneten Schaltmitteln des Schaltwerkes diejenigen Zeitpunkte vorzugeben, an denen die nächsten H-Signale des Umformers zu erwarten sind. Das erste H-Signal des Umformers beaufschlagt den einen Eingang eines UND-Gliedes U1, dessen anderer Eingang durch das Ausgangspotential einer bistabilen Kippstufe BK beeinflusst ist. Diese bistabile Kippstufe war vor Beginn des Messvorganges bzw. nach dem Auftreten einer vorangegangenen Störung durch ein auf die Eingangsklemme A gegebenes Steuerkennzeichen in die in Figur 5 dargestellte Ausgangsstellung gesteuert worden, in der es an seinem linken Ausgang H-Potential führt. Das beim ersten Ansprechen des Umformers am Ausgang des UND-Gliedes U1 auftretende Signal steuert die bistabile Kippstufe BK in die nicht dargestellte Arbeitsstellung, in der diese über ihren rechten Ausgang Steuerpotential (H) auf den einen Eingang eines UND-Gliedes U2 schaltet. Gleichzeitig mit dem Umsteuern der bistabilen Kippstufe BK gelangt ein Signal auf den Einschalteingang eines Zählers Z. Dieser Zähler dient dazu, die am Ausgang des Frequenzteilers T1 abgreifbaren Schwingungen der Frequenz f2 zu zählen und den Zeitpunkt festzulegen, an dem das nächste H-Signal des Umformers UF betriebsmässig zu erwarten ist. Hierzu ist der Zähler Z auf eine vorgebbare Zählstellung voreinzustellen, die abhängig ist von dem Faktor $\Delta f2$ für die Frequenzverschiebung der beiden Frequenzteiler T1 und T2. Nach der voreingestellten Anzahl von Schwingungen $1/\Delta f2 = 6$ gibt der Zähler Z (Figur 3, Zeile 6) an seinem Ausgang H-Potential auf den einen Eingang eines Exklusiv-ODER-Gliedes EO. Der andere Eingang dieses Gliedes ist an den Ausgang des UND-Gliedes U2 angeschlossen, das bei jedem auf das erste H-Signal folgenden H-Signal des Umformers UF H-Potential (Figur 3, Zeile 5) führt.

Solange die Frequenz der zu überwachenden Schwingschaltung stabil ist, wird das Exklusiv-ODER-Gied stets durch gleichartige Signale beaufschlagt, so dass sein Ausang L-Potential führt. Wenn aufgrund einer Frequenzdrift oder eines Bauelementfehlers eines der vom Umformer UF ausgegebenen H-Signale zeitlich gesehen nicht mit dem Ausgangssignal des Zählers Z zusammentrifft, werden die beiden Eingänge des Exklusiv-ODER-Gliedes EO mindestens vorübergehend durch unterschiedliche Signale beaufschlagt. Die Folge davon ist, dass das Exklusiv-ODER-Glied an seinem Ausgang H-Potential führt und damit das Ausgeben einer Meldung veranlasst.

Figur 2 zeigt eine gegenüber Figur 1 abgewandelte Ausführungsform der erfindungsgemässen Einrichtung. Für einander entsprechende Schaltungselemente sind die gleichen Bezugszeichen wie in Figur 1 gewählt worden. Die Ausgänge der beiden Frequenzteiler T1 und T2 sind auf die Eingänge eines nachgeschalteten UND-Gliedes U3 geführt. Dem UND-Glied U3 nachgeschaltet ist eine monostabile Kippstufe MK, die durch die Rückflanken der vom UND-Glied U3 ausgelösten Signale gesteuert wird. Die Ausgangssignale der monostabilen Kippstufe steuern zusammen mit den Ausgangssignalen des Frequenzteilers T1 das Schaltwerk SW der Figur 5. Zur Verdeutlichung der Wirkungsweise der Einrichtung nach Figur 2 ist auf das Schaubild der Figur 4 Bezug genommen. Die ersten beiden Zeilen der Figur 4 zeigen die zu überwachende Schwingung mit der Frequenz f2 und die Bezugsschwingung mit der Frequenz f3; die Periodendauer der Bezugsschwingung soll wiederum um 20% länger sein als die Periodendauer der zu überwachenden Schwingung.

Solange die beiden Frequenzteiler T1 und T2 gleichzeitig H-Potential führen, führt auch das UND-Glied U3 an seinem Ausgang H-Potential. Zeile 3 der Figur 4 zeigt deutlich, dass die Zeitspannen, in denen am Ausgang des UND-Gliedes U3 H-Potential anliegt, mit zunehmender zeitlicher Verschiebung der an den Eingängen des UND-Gliedes anliegenden Schwingungen immer kürzer werden, um dann wieder grösser und anschliessend wieder kürzer zu werden. Die dem monostabilen Kippglied MK eingeprägte Schaltzeit ist so bemessen, dass sie einer Periode der zu überwachenden Schwingung entspricht. Dies bedeutet, dass das monostabile Kippglied MK ausgangsseitig so lange H-Potential führt, so lange ihm vom UND-Glied U3 spätestens nach jeweils einer Periode der zu überwachenden Schwingung ein Steuersignal zugeführt wird. Zeile 4 der Figur 4 zeigt, dass diese Bedingung nicht immer erfüllt ist und dass nach jeweils $1/\Delta f2 = 6$ Perioden der zu überwachenden Schwingung das monostabile Kippglied MK an seinem Ausgang L-Potential führt. Die durch L-Potential definierten Ausgangssignale MKA (Figur 4, Zeile 4) des monostabilen Kippgliedes MK steuern den Umformer des Schaltwerkes SW (Figur 4, Zeile 5) und bewirken damit die Ansteuerung des Exklusiv-ODER-Gliedes EO. Wenn und solange der Zähler des Schaltwerkes gleichzeitig mit den Ausgangssignalen des Umformers H-Potential führt, bleibt das Exklusiv-ODER-Glied ausgangsseitig auf L-Potential geschaltet. Findet keine zeitliche Überdeckung der Ausgangssignale des Umformers und des Zählers statt, so führt das Exklusiv-ODER-Glied ausgangsseitig H-Potential und löst durch Anschalten des Melders M eine Meldung aus.

Durch Vorgeben eines bestimmten Zählbereiches lässt sich die zeitliche Dauer, in der der Zähler ausgangsseitig H-Potential führt, variieren. Auf diese Weise ist es möglich, ein eine Frequenzdrift kennzeichnendes Signal nur dann auszulösen, wenn die Frequenzdrift vorgegebene Grenzen in der einen oder anderen bzw. einer von beiden Richtungen übersteigt. Im Schaubild nach Figur 4 ist dieser Möglichkeit durch zeitliche Verlängerung der Ausgangssignale des Zählers Z Rechnung getragen.

Bei den vorstehenden Ausführungsbeispielen war angenommen worden, dass zum Ausgeben einer Störungsmeldung die in Grundstellung befindlichen Melder M durch das Ausgangspotential eines Exklusiv-ODER-Gliedes zu beaufschlagen waren. Es ist aber auch möglich und durchaus vorteilhaft, die Melder nach dem Ruhestromprinzip zu betreiben, also zu Beginn des Überwachungsvorganges anzuschalten und durch Dauerpotential in ihrer Wirkstellung zu halten, bis das Schaltwerk eine unzulässige Frequenzdrift erkannt hat. In diesem Falle ist das Exklusiv-ODER-Glied des Schaltwerkes SW durch ein Äquivalenzglied zu ersetzen. Desgleichen ist es möglich, die Speisung des dem Schaltwerk nachgeschalteten Melders über vom Zähler und vom Umformer gesteuerte Ausgabeverstärker vorzunehmen.

Das bei dem Ausführungsbeispiel nach Figur 2 vorgesehene monostabile Kippglied kann auch als vom vorgeschalteten UND-Glied rückstellbares Verzögerungsglied mit einer der Periodendauer der zu überwachenden Schwingung entsprechenden Verzögerungszeit ausgebildet sein; allerdings ist dann das Schaltverhalten des nachgeschalteten Umformers an die Form der von dem Verzögerungsglied abgegebenen Signale anzupassen.

Bei den vorstehend näher erläuterten Ausführungsbeispielen waren die Messzeiten, in denen die gegenseitige Phasenlage der zu überwachenden Schwingung und der Bezugsschwingung zueinander erfasst wurden, jeweils so gewählt, dass diese Schwingungen vom Beginn bis zum Ende der Messzeit einen Phasenversatz von 360° aufwiesen; dabei differierten die Periodenzahlen der beiden Schwingungen um ±1. Diese Differenz kann jedoch auch grösser gewählt sein, z.B. 2, 3 oder 4 Perioden. In diesem Falle wäre dem vom Umformer gesteuerten Eingang des Exklusiv-ODER-Gliedes ein entsprechend untersetzender Zähler vorzuschalten.

Zur Realisierung der Erfindung ist es aber nicht unbedingt erforderlich, dass die zu bewertenden Schwingungen innerhalb der einzelnen Messzeiten einen Phasenversatz um 360° aufweisen; vielmehr kann durch entsprechende Voreinstellung des Zählers jeder beliebige Phasenversatz vorgegeben werden. Vorteilhaft ist jedoch ein besonders markanter Phasenversatz, also z.B. ein solcher von n × 180° oder n × 360°, weil ein solcher Phasenversatz digital feststellbar ist.

Die erfindungsgemässe Einrichtung zum Erkennen der Frequenzdrift einer Schwingschaltung kann ständig wirksam sein, d.h. auch relativ geringfügige Driftvorgänge über längere Zeiträume sind erkennbar. Bei zyklischer oder bedarfsweiser Rückstellung der Einrichtung über die Eingangsklemme A des Schaltwerkes lassen sich Driftvorgänge innerhalb vorgegebener Messzeiten erfassen; dies ist dann von Interesse, wenn eine mögliche Frequenzverschiebung nur zeitlich begrenzt Auswirkungen hat, weil z.B. ein schwingungsgesteuertes oder -überwachtes Gerät nur in vorgegebenen Zeitabschnitten wirksam ist und mögliche Frequenzverschiebungen ausserhalb dieser Messzeit unberücksichtigt bleiben können.

**Patentansprüche**

1. Einrichtung zum Erkennen der Frequenzdrift einer Schwingschaltung (G1, T1) unter Verwendung einer weiteren Schwingschaltung (G2, T2) zur Vorgabe einer Bezugsschwingung (f3) und einer den beiden Schwingschaltungen nachgeschalteten Phasenvergleichsschaltung zum Feststellen der zeitlichen Beziehung der beiden Schwingungen (f2, f3) zueinander, dadurch gekennzeichnet, dass die Schwingschaltung (G2, T2) für die Bezugsfrequenz (f3) eine um einen Faktor $\Delta f2$ von der Frequenz der zu überwachenden Schwingung (f2) abweichende Frequenz (f3) erzeugt, und dass die Phasenvergleichsschaltung (T3, K, SW bzw. U3, MK, SW) prüft, ob und wann die beiden Schwingungen (f2, f3) – ausgehend von einer beliebigen Phasenbeziehung – zueinander eine Phasenverschiebung von 180° oder ein ganzzahliges Vielfaches n hiervon erfahren, indem sie ein Zeitfenster (Z in Figur 3 bzw. Figur 4) vorgibt, innerhalb dessen für die beiden Schwingungen diese Phasenverschiebung zu erwarten ist, wobei die Phasenvergleichsschaltung eine Meldung auslöst, wenn die beiden Schwingungen nicht nach jeweils $n/\Delta f2$-Perioden der zu überwachenden Schwingung (f2) die vorgegebene Phasenverschiebung zueinander erfahren haben.

2. Einrichtung nach Anspruch 1, dadurch gekennzeichnet, dass jede Schwingschaltung aus einem quarzstabilen Oszillator (G1, G2) mit nachgeschaltetem Frequenzteiler (T1, T2) besteht.

3. Einrichtung nach Anspruch 1 oder 2, dadurch gekennzeichnet, dass die Phasenvergleichsschaltung ein D-Kippglied (K) beinhaltet, dessen Takteingang (C) an den Ausgang der Schwingschaltung (G1, T1) für die zu überwachende Schwingung (f2) und dessen Signaleingang (D) an den Ausgang eines Frequenzteilers (F3) angeschlossen ist, der eingangsseitig mit dem Ausgang der Schwingschaltung (G2, T2) für die Bezugsfrequenz (F3) verbunden ist und der die ihm zugeführten Schwingungen im Verhältnis 2:1 teilt und dass an den Ausgang des Kippgliedes (K) ein das zyklische Umsteuern des Kippgliedes (K) erfassendes Schaltwerk (SW) angeschlossen ist, welches dann die eine Frequenzdrift der zu überwachenden Schwingschaltung (G1, T1) kennzeichnende Meldung ausgibt, wenn nicht am Ausgang des D-Kippgliedes (K) alle $n/\Delta f2$-Perioden der zu überwachenden Schwingung (f2) ein über zwei Perioden unverändert andauerndes Ausgangssignal (KA) ansteht.

4. Einrichtung nach Anspruch 1, dadurch gekennzeichnet, dass die Phasenvergleichsschaltung ein monostabiles Kippglied (MK) beinhaltet, das über ein vorgeschaltetes UND-Glied (U3) an die Ausgänge der beiden Schwingschaltungen (G1, T1; G2, T2) angeschlossen ist und vom UND-Glied (U3) jeweils mit der Rückflanke seiner Ausgangssignale steuerbar ist, dass die dem monostabilen Kippglied (MK) eingeprägte Schaltzeit der Periodendauer der zu überwachenden Schwingfrequenz (f2) entspricht und dass der Ausgang des monostabilen Kippgliedes (MK) auf ein Schaltwerk (SW) geführt ist, welches dann die eine Frequenzdrift der zu überwachenden Schwingschaltung (G1, T1) kennzeichnende Meldung ausgibt, wenn nicht am Ausgang des monostabilen Kippgliedes (MK) alle $n/\Delta f2$-Perioden der zu überwachenden Schwingung (f2) ein Signalwechsel (MKA) auftritt.

5. Einrichtung nach Anspruch 4, dadurch gekennzeichnet, dass das monostabile Kippglied (MK) als rückstellbares Verzögerungsglied mit einer der Periodendauer der zu überwachenden Schwingung (f2) entsprechenden Verzögerungszeit ausgebildet ist.

6. Einrichtung nach Anspruch 3, 4 oder 5 dadurch gekennzeichnet, dass das Schaltwerk (SW) einen zum Auszählen der $n/\Delta f2$-Perioden der Schwingfrequenz (f2) dienenden Zähler (Z) aufweist.

7. Einrichtung nach Anspruch 6, dadurch gekennzeichnet, dass der Zähler (Z) zum Erfassen einer Frequenzdrift ausserhalb eines zulässigen Driftbereiches auf einen unteren und einen oberen Betrag voreinstellbar ist, und dass das Schaltwerk eine Meldung ausgibt, wenn die sie steuernden Ausgangssignale jeweils ausserhalb des durch diese Beträge vorgegebenen Periodenbereiches auftreten.

**Claims**

1. A device for recognising the frequency drift of an oscillatory circuit (G1, T1), using a further oscillatory circuit (G2, T2) to predetermine a reference oscillation (f3), and using a phase comparison circuit connected to the output end of the two oscillatory circuits and which serves to establish the time relationship between the two oscillations (f2, f3), characterised in that the oscillatory circuit (G2, T2) for the reference frequency (f3) produces a frequency which deviates by a factor $\Delta f2$ from the frequency of the oscillation (f2) to be monitored, and that the phase comparison circuit (T3, K, SW; or U3, MK, SW as the case may be) checks whether and when the two oscillations (f2, f3) – commencing from an arbitrary phase relationship – experience a phase shift of 180° or a whole numbered multiple thereof relative to one another, in that it presets a time window (Z in Fig. 3 and Fig. 4) within which this phase shift is to be expected for the two oscillations, where the phase comparison circuit triggers a message when the two oscillations have not experienced the prescribed phase shift relative to one another in each case after n/Δf2 periods of the oscillation (f2) to be monitored.

2. A device as claimed in Claim 1, characterised in that each oscillating circuit consists of a quartz-stable oscillator (G1, G2) connected at the output end to a frequency divider (T1, T2).

3. A device as claimed in Claim 1 or 2, characterised in that the phase comparison circuit contains a D-type trigger stage (K) whose clock pulse input (C) is connected to the output of the oscillatory circuit (G1, T1) for the oscillation (f2) to be monitored, and whose signal input (D) is connected to the output of a frequency divider (F3) connected at its input to the output of the oscillatory circuit (G2, T2) for the reference frequency (F3) and which divides the oscillations with which it is supplied in the ratio 2:1, and that the output of the D-type trigger stage (K) is connected to a switching mechanism (SW) which detects the cyclic switch-over of the trigger element (K) and emits the message which characterises a frequency drift of the oscillatory circuit (G1, T1) to be monitored when an output signal (KA) which continues unchanged for two periods does not occur every n/Δf2 periods at the output of the D-type trigger stage (K).

4. A device as claimed in Claim 1, characterised in that the phase comparison circuit contains a monostable trigger stage (MK) connected via a series-connected AND-gate (U3) to the outputs of the two oscillatory circuits (G1, T1; G2, T2) and can be controlled via the AND-gate (U3) by the rear flank of each of its output signals, that the switching time impressed upon the monostable trigger stage (MK) corresponds to the period duration of the oscillation frequency (f2) to be monitored, and that the output of the monostable trigger stage (MK) leads to a switching mechanism (SW) which emits a message which characterises the oscillatory circuit (G1, T1) to be monitored, when a signal change (MKA) does not occur at the output of the monostable trigger stage (MK) every n/Δf2 periods.

5. A device as claimed in Claim 4, characterised in that the monostable trigger stage (MK) is designed as a delay element having reset facilities and a delay time which corresponds to the period duration of the oscillation (f2) to be monitored.

6. A device as claimed in Claim 3, 4 or 5, characterised in that the switching mechanism comprises a counter (Z) which serves to count the n/Δf2 periods of the oscillation frequency (f2).

7. A device as claimed in Claim 6, characterised in that, in order to detect a frequency drift outside of a permissible drift range, the counter (Z) can be preset at a lower and an upper amount, and that the switching mechanism emits a message when the output signals by which it is controlled occur outside of the period range governed by these amounts.

**Revendications**

1. Dispositif pour détecter le glissement de fréquence d'un circuit oscillant (G1, T1) grâce à l'utilisation d'un autre circuit oscillant (G2, T2) pour la prédétermination d'une oscillation de référence (f3), et d'un circuit comparateur de phase, branché en aval des deux circuits oscillants et servant à déterminer la relation dans le temps entre les deux oscillations (f2, f3), caractérisé par le fait que le circuit oscillant (G2, T2) servant à produire la fréquence de référence (f3) produit une fréquence (f3) s'écartant d'un facteur Δf2 de la fréquence de l'oscillation (f2) devant être contrôlée, et que le circuit comparateur de phase (T3, K, SW ou U3, MK, SW) contrôle si et quand les deux oscillations (f2, f3) subissent – à partir d'une position de phase quelconque – un déphasage réciproque égal à 180° ou à un multiple entier de cette valeur, grâce au fait qu'il fixe à l'avence un créneau temporel (Z sur la figure 3 ou la figure 4) à l'intérieur duquel il faut s'attendre à obtenir ce déphasage pour les deux oscillations, le circuit comparateur de phase déclenchant une signalisation lorsque les deux oscillations n'ont pas subi le déphasage réciproque prédéterminé au bout respectivement de n/Δf2 périodes de l'oscillation (f2) devant être contrôlée.

2. Dispositif suivant la revendication 1, caractérisé par le fait que chaque circuit oscillant est constitué par un oscillateur (G1, G2) stabilisé par quartz, en aval duquel est branché un diviseur de fréquence (T1, T2).

3. Dispositif suivant la revendication 1 ou 2, caractérisé par le fait que le circuit comparateur de phase contient un circuit à bascule bistable de type D (K), dont l'entrée de cadence (C) est raccordée à la sortie du circuit oscillant (G1, T1) servant à délivrer l'oscillation (f2) devant être contrôlée, et dont l'entrée des signaux (D) est raccordée à la sortie d'un diviseur de fréquence (F3), qui est raccordée, du côté entrée, à la sortie du circuit oscillant (G2, T2) servant à délivrer la fréquence de référence (F3), et qui divise dans le rapport 2:1 les oscillations qui lui sont envoyées, et qu'à la sortie de l'étage à bascule bistable de type D (K) est raccordé un dispositif de commutation (SW) qui détermine la commande d'inversion cyclique de l'étage à bascule bistable (K) et qui délivre la signalisation caractérisant un glissement de fréquence du circuit oscillant (G1, T1) devant être contrôlé, lorsqu'aucun signal de sortie restant inchangé pendant deux périodes n'apparaît à la sortie du circuit à bascule bistable de type D (K), toutes les n-Δf2 périodes de l'oscillation (f2) à côntroler.

4. Dispositif suivant la revendication 1, caractérisé en ce que le circuit comparateur de phase contient un circuit à bascule monostable (MK) qui est raccordé par l'intermédiaire d'un circuit ET (U3) branché en aval, aux sorties des deux circuits oscillants (G1, T1; G2, T2) et peut être commandé par le circuit ET (U3) respectivement par le flanc arrière de ses signaux de sortie, que le temps de commutation imposé au circuit à bascule monostable (MK) correspond à la durée de la période de la fréquence d'oscillation (f2) devant être contrôlée et que le signal de sortie du circuit à bascule monostable (MK) est envoyé à un mécanisme de commutation (SW) qui délivre la signalisation caractérisant le glissement de fréquence du circuit oscillant (G1, T1) à contrôler, lorsqu'aucun changement de signal n'apparaît à la sortie du circuit à bascule monostable (MK), toutes les n$\Delta$f2 pérodes de l'oscillation (f2) à contrôler.

5. Dispositif suivant la revendication 4, caractérisé par le fait que le circuit à bascule monostable (MK) est réalisé sous la forme d'une ligne à retard pouvant être ramenée à l'état initial et appliquant un temps de retard correspondant à la durée de la période de l'oscillation (f2) à contrôler.

6. Dispositif suivant la revendication 3, 4 ou 5, caractérisé par le fait que le mécanisme de commutation (SW) comporte un compteur (Z) servant à compter les n/$\Delta$f2 périodes de la fréquence d'oscillation (f2).

7. Dispositif suivant la revendication 6, caractérisé par le fait que le compteur (Z) peut être préréglé sur une valeur inférieure et sur une valeur supérieure, pour la détermination d'un glissement de fréquence à l'extérieur d'une plage de glissement admissible et que le dispositif de commutation délivre une signalisation lorsque les signaux de sortie, qui commandent cette dernière apparaissent respectivement à l'extérieur de la période prédéterminée par ces valeurs.

# FIG 1

# FIG 2

# FIG 5

0 050 744

# FIG 3

# FIG 4